# EUROPEAN PATENT SPECIFICATION

(11) **EP 4 546 392 B1**
(45) Date of publication and mention of the grant of the patent: **18.02.2026**
(21) Application number: 24206979.7
(22) Date of filing: 16.10.2024
(51) Int. Cl.: H01J 37/04, H01J 3/02, H01J 37/06, H01J 37/24

(54) **CHARGED PARTICLE GUN AND CHARGED PARTICLE BEAM SYSTEM**
LADUNGSTRÄGERTEILCHKANONE UND SYSTEM FÜR LADUNGSTRÄGERTEILCHENSTRAHLEN
CANON À PARTICULES CHARGÉES ET SYSTÈME À FAISCEAU DE PARTICULES CHARGÉES

(30) Priority: 24.10.2023 JP 2023182564
(43) Date of publication of application: 30.04.2025
(73) Proprietor: JEOL Ltd., Akishima, Tokyo 196-8558 (JP)
(72) Inventor: KOHNO, Yuji, Tokyo, 196-8558 (JP); SAWADA, Hidetaka, Tokyo, 196-8558 (JP); IKEDA, Akihiro, Tokyo, 196-8558 (JP)
(74) Representative: Boult Wade Tennant LLP

(56) References cited:
- JP-B1- S 492 860
- US-A- 4 629 937

## Description

### BACKGROUND OF THE INVENTION

### 1. Field of the Invention

The present invention relates to a charged particle gun and a charged particle beam system.

### 2. Description of the Related Art

Patent document 1 discloses a pulsed electron source which is capable of emitting a pulsed electron beam and which is for use in an electron microscope such as a scanning electron microscope or a transmission electron microscope.

A method of implementing a pulsed electron source is to cause an electron beam emanating from an electron gun to be blanked at high speed with a blanker so as to be pulsed. In this method, if a high-brightness Schottky emission gun or a cold field emission gun is used, a pulsed electron source of high brightness is obtained. US4629937A discloses a pulsed electron source with a capacitor coupled to the extraction electrode.

### Citation List

### Patent Documents

Patent document 1: JP-A-2000-208080

With the above-described method of emitting an electron beam while pulsing it with the beam blanker, however, there are a limited number of electrons in each pulse.

### SUMMARY OF THE INVENTION

One aspect of a charged particle gun associated with the present invention is operative to emit a charged particle beam and comprises:
an emitter;
an extraction electrode for extracting the charged particle beam from the emitter;
a capacitor having one end connected to the extraction electrode;
a first power supply for supplying a first voltage to the one end of the capacitor via a resistor;
a second power supply providing an output of a second voltage; and
a switch circuit that switches between whether the second voltage or a reference potential is supplied to the other end of the capacitor, based on a reference pulsed signal.

In this charged particle gun, the first voltage is supplied to the one end of the capacitor, and the reference potential is supplied to the other end of the capacitor. In this state, electric charge corresponding to the difference between the first voltage and the reference potential is stored in the capacitor. The voltage applied to the other end of the capacitor is switched to the second voltage based on the reference pulsed signal. As a result, the voltage applied to the extraction electrode can be varied in a pulsed manner. Consequently, the emission current can be varied in a pulsed manner. Hence, the number of charged particles contained in each pulse can be increased.

One aspect of the charged particle beam system associated with the present invention includes the charged particle gun described above.

### BRIEF DESCRIPTION OF THE DRAWINGS

FIG. 1 is a schematic diagram showing the configuration of an electron gun associated with a first embodiment of the present invention.
FIGS. 2 and 3 are graphs of the emission current EC of the electron beam emitted from the electron gun of FIG. 1.
FIG. 4 is a graph showing a reference pulsed signal SAp, an inverted signal SB, a voltage signal SC, an emission current EC0, a blanking signal SD, and the emission current EC in a pulsed emission mode.
FIG. 5 is a graph showing a reference continuous signal SAc, inverted signal SB, voltage signal SC, emission current EC0, and emission current EC in a continuous emission mode.
FIG. 6 is a graph showing a comparative example of a method of emitting an electron beam in a pulsed manner.
FIG. 7 is a schematic diagram showing the configuration of an electron gun associated with a second embodiment.
FIG. 8 is a graph of the emission current EC of the electron beam emitted from the electron gun of FIG. 7.
FIG. 9 is a graph showing the reference pulsed signal SAp, inverted signal SB, voltage signal SC, emission current EC0, and emission current EC when the electron gun of FIG. 7 is in the pulsed emission mode.
FIG. 10 is a graph showing the reference pulsed signal SAp, inverted signal SB, voltage signal SC, emission current EC0, and emission current EC when the electron gun of FIG. 7 is in a modified pulsed emission mode.
FIG. 11 is a diagram showing the configuration of an electron microscope associated with a third embodiment.

### DETAILED DESCRIPTION OF THE INVENTION

The preferred embodiments of the present invention are hereinafter described in detail with reference to the accompanying drawings. It is to be noted that the embodiments described below are not intended to unduly restrict the scope and spirit of the present invention delineated by the appended claims and that not all the configurations described below are the essential constituent components of the present invention.

In the following example, an electron gun for emitting an electron beam is taken as one example of a charged particle gun associated with the present invention. The charged particle gun associated with the present invention may also be a gun for emitting a charged particle beam other than an electron beam such as an ion beam.

### 1. First Embodiment

### 1.1. Structure of Electron Gun

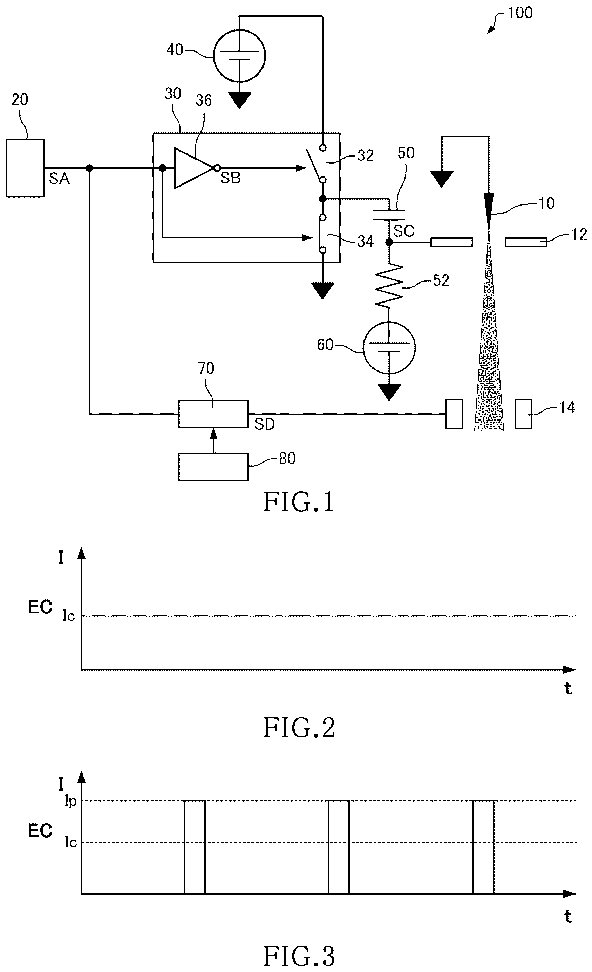

An electron gun associated with a first embodiment is first described by referring to FIG. 1, which shows the structure of the electron gun, 100, associated with the first embodiment. As shown, the electron gun 100 includes an emitter 10, an extraction electrode 12, a beam blanker 14, a reference signal generator 20, a switch circuit 30, a pulsed power supply 40 (one example of a second power supply), a capacitor 50, a resistor 52, an offset power supply 60 (one example of a first power supply), and a blanking signal generator circuit 70. The electron gun 100 has a pulsed emission mode in which an electron beam is emitted in a pulsed manner and a continuous emission mode in which an electron beam is emitted at a constant emission current.

The emitter 10 is a source of electrons, i.e., a cathode. For example, a tungsten tip having a front end whose diameter is on the order of nanometers can be used as the emitter 10. The emitter 10 is connected to a reference potential.

The extraction electrode 12 is used to extract electrons from the emitter 10. An extraction voltage that is a high positive voltage for producing a strong electric field on the surface of the emitter 10 is applied between the emitter 10 and the extraction electrode 12.

The electron gun 100 is a field-emission electron gun that produces a strong electric field at the tip of the emitter 10 to emit electrons by the tunnel effect. The electron gun 100 may also be a Schottky emission gun that induces a strong electric field at the tip of the emitter 10 to emit electrons by the Schottky effect.

The beam blanker 14 blanks the electron beam emanating from the emitter 10, i.e., cuts off the electron beam by deflecting it. An electrostatic deflector consisting of a pair of plates capable of turning the beam on and off quickly can be used as the blanker 14. Consequently, the electron beam can be blanked and unblanked at high speed.

The beam blanker 14 is positioned between the extraction electrode 12 and a sample irradiated with an electron beam. No restrictions are imposed on the position of the blanker 14 as long as it is located between the extraction electrode 12 and the sample. For example, the blanker 14 may be incorporated in the illumination optics of the electron microscope.

The reference signal generator 20 produces a reference signal SA. In the pulsed emission mode, the reference signal generator 20 produces a pulsed reference signal as the reference signal SA. In the continuous emission mode, the reference signal generator 20 produces a continuous reference signal as the reference signal SA. The reference signal SA is applied to the switch circuit 30 and to the blanking signal generator circuit 70.

The switch circuit 30 switches between whether the pulsed voltage from the pulsed power supply 40 or the reference potential (ground potential) is supplied to the capacitor 50, based on the reference signal SA.

The switch circuit 30 includes a first switch 32, a second switch 34, and an inverter 36. The pulsed power supply 40 is connected to one end of the first switch 32, the capacitor 50 being connected to the other end of the first switch 32. A reference potential is connected to one end of the second switch 34, while the capacitor 50 is connected to the other end of the second switch 34.

The logic level of the reference signal SA is inverted by the inverter 36, resulting in an inverted signal SB which is applied to the first switch 32. The reference signal SA is directly applied to the second switch 34. Therefore, the first switch 32 and the second switch 34 operate mutually exclusively. That is, when the first switch 32 is on, the second switch 34 is off. Conversely, when the first switch 32 is off, the second switch 34 is on. In the switch circuit 30, if the first switch 32 is on, the second switch 34 cannot go on. The first switch 32 and the second switch 34 can be accomplished, for example, using push-pull circuits or relay circuits.

The pulsed power supply 40 outputs a pulsed voltage (herein referred to also as the second voltage). One end of the pulsed power supply 40 is connected to the switch circuit 30, while the other end is connected to the reference potential. The pulsed voltage can be set to any arbitrary value.

One end of the capacitor 50 is connected to the extraction electrode 12, while the other end of the capacitor 50 is connected to the switch circuit 30. A voltage signal SC is applied to the extraction electrode 12.

The offset power supply 60 supplies an offset voltage (herein referred to also as the first voltage) to the one end of the capacitor 50 via the resistor 52. One end of the offset power supply 60 is connected to the one end of the capacitor 50 via the resistor 52, the other end of the offset power supply 60 being connected to the reference potential. The offset voltage can be set to any arbitrary value.

The blanking signal generator circuit 70 generates a blanking signal SD synchronized with the reference signal SA, based on a user's instruction accepted by a controller 80. The blanking signal SD generated by the blanking signal generator circuit 70 is applied to the beam blanker 14 that operates in response to the blanking signal SD.

The controller 80 accepts the user's instruction and controls the blanking signal generator circuit 70 in response to the instruction. The controller 80 includes a processor (such as a CPU (central processing unit)) and memories (such as RAM (random access memory) and ROM (read only memory)). Programs and data for various kinds of control operations are stored in the memories. The functions of the controller 80 can be implemented by executing programs by means of the processor.

### 1.2. Operation

### 1.2.1. Emission of Electron Beam

FIGS. 2 and 3 are graphs showing the emission current EC of the electron beam released from the electron gun 100. The electron gun 100 can switch between the continuous emission mode in which an electron beam is emitted at a constant emission current as shown in FIG. 2 and the pulsed emission mode in which an electron beam is emitted in a pulsed manner as shown FIG. 3. In the continuous emission mode, the electron beam can be directed at the sample with a constant emission current. In the pulsed emission mode, an electron beam can be directed in a pulsed manner at the sample at intervals, for example, on the order of microseconds. In the pulsed emission mode, the emission current EC has a peak current intensity of Ip (Ip ≠ 0). In the continuous emission mode, the emission current EC has an electrical current value of Ic (Ic ≠ 0). The peak current intensity Ip is greater than the current value Ic.

### 1.2.2. Pulsed Emission Mode

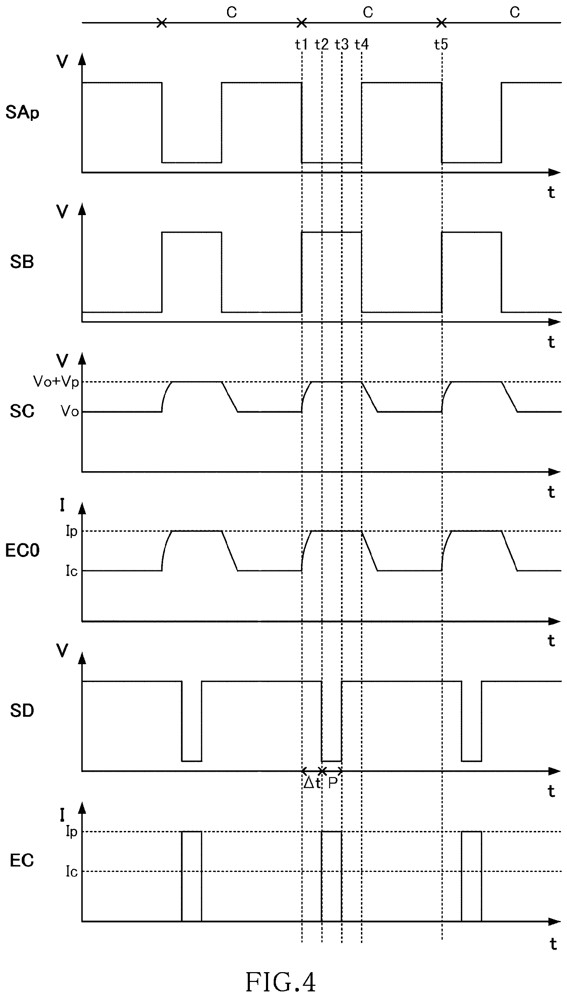

FIG. 4 is a graph showing the reference pulsed signal SAp, inverted signal SB, voltage signal SC, emission current EC0, blanking signal SD, and emission current EC in the pulsed emission mode. The emission current EC0 is the electron current emanating from the emitter 10 prior to the incidence of the electron beam on the blanker 14. The emission current EC is taken at a stage later than the blanker 14. That is, the emission current EC is the emission current of the electron beam emitted from the electron gun 100.

In the pulsed emission mode, the switch circuit 30 switches between whether the pulsed voltage Vp or the reference potential is supplied to the other end of the capacitor 50 whose one end is supplied with the offset voltage Vo according to the reference pulsed signal SAp and varies the voltage signal SC applied to the extraction electrode 12 in a pulsed manner. As a result, the emission current EC0 varies in a pulsed manner.

The beam blanker 14 performs blanking according to the blanking signal SD synchronized to the reference pulsed signal SAp, thereby extracting some of the pulses of the emission current EC0. As a result, the electron gun 100 emits an electron beam in a pulsed manner.

The operation of the electron gun 100 for one cycle C from instant of time t1 to instant of time t5 is described in detail below. At the instant t1, the reference signal generator 20 switches the logic level of the reference pulsed signal SAp from a high to a low level. Consequently, the reference pulsed signal SAp of a low level is applied to the inverter 36. The logic level of the reference pulsed signal SAp is inverted by the inverter 36. Therefore, the inverted signal SB of a high level is applied to the first switch 32, whereby the first switch 32 is turned on. The reference pulsed signal SAp of a low level is directly applied to the second switch 34, so that the second switch 34 goes off.

Because the first switch 32 goes on and the second switch 34 goes off, the pulsed voltage Vp is supplied to the other end of the capacitor 50. That is, the voltage applied to the other end of the capacitor 50 is switched from the reference potential to the pulsed voltage Vp. On the other hand, the offset power supply 60 is connected to the one end of the capacitor 50 via the resistor 52 and so the offset voltage Vo is supplied to the one end of the capacitor 50. Because the voltage applied to the other end of the capacitor 50 is switched from the reference potential to the pulsed voltage Vp, the voltage value of the voltage signal SC increases gradually from the offset voltage Vo according to a time constant determined by both the capacitance of the capacitor 50 and the resistance value of the first switch 32 and is kept constant at the sum of the offset voltage Vo and the pulsed voltage Vp, i.e., Vo + Vp.

For example, if the pulsed voltage Vp is 1.2 kV and the offset voltage Vo is 3.0 kV, the voltage value of the voltage signal SC applied to the extraction electrode 12 increases gradually from 3.0 kV and is kept constant at 4.2 kV.

At this time, the voltage value of the voltage signal SC is ideally kept constant at the sum Vo + Vp but electrical charge stored in the capacitor 50 is discharged via the resistor 52 and thus decreases gradually. However, in a time sufficiently shorter than the time constant determined by the capacitance of the capacitor 50 and the resistance value of the resistor 52, the electrical charge in the capacitor 50 does not vary greatly and the voltage value of the voltage signal SC can be regarded as constant. Consequently, it is assumed that the time constant determined by the capacitance of the capacitor 50 and the resistance value of the resistor 52 is sufficiently greater than the pulse width of the reference pulsed signal SAp.

Since the voltage value of the voltage signal SC applied to the extraction electrode 12 becomes equal to the sum Vo + Vp, the electrical current value of the emission current ECo of the electron beam emanating from the emitter 10 becomes equal to current Ip.

At the instant t1, the blanking signal generator circuit 70 maintains the logic level of the blanking signal SD at a high level. Accordingly, at the instant t1, the blanker 14 blanks the electron beam, and the electrical current value of the emission current EC of the electron beam emanating from the electron gun 100 is zero.

At an instant t2 at which a given time Δt has elapsed since the instant t1, the blanking signal generator circuit 70 switches the logic level of the blanking signal SD from a high to a low level. The blanking signal generator circuit 70 maintains the low level for a given period of P from the instant t2. Thus, the blanker 14 does not blank the electron beam during the given period P from the instant t2. As a result, the electrical current value of the emission current EC is the electrical current Ip during the given period P from the instant t2.

At an instant t3 at which the given period P has elapsed since the instant t2, the blanking signal generator circuit 70 switches the logic level of the blanking signal SD from a low to a high level. Thus, the blanker 14 starts blanking of the electron beam at the instant t3. As a result, at the instant t3, the emission current EC has an electrical current value of zero.

The blanking signal generator circuit 70 includes, for example, a delay circuit for controlling the time Δt and a control circuit for controlling the given period P corresponding to a pulse width. The time Δt and the given period P can be set to arbitrary values, and are set based on a user's instruction accepted by the controller 80. For example, by setting the time Δt longer than the time which elapses from the instant t2 and in which the voltage value of the voltage signal SC settles into the sum Vo + Vp, it is possible to obtain a pulsed electron beam having a stable peak intensity. Furthermore, by setting the given period P to the order of microseconds, it is possible to obtain a pulsed electron beam having a pulse width on the order of microseconds.

At an instant t4, the reference signal generator 20 switches the logic level of the reference pulsed signal SAp from a low to a high level. Consequently, the reference pulsed signal SAp of a high level is applied to the inverter 36. The reference pulsed signal SAp is inverted in logic level by the inverter 36. Accordingly, the inverted signal SB of a low level is applied to the first switch 32, thus turning off the first switch 32. The reference pulsed signal SAp of a high level is directly applied to the second switch 34, thus turning on the second switch 34.

Because the first switch 32 is turned off while the second switch 34 is turned on, the reference potential is supplied to the other end of the capacitor 50. That is, the voltage applied to the other end of the capacitor 50 is switched from the pulsed voltage Vp to the reference potential. On the other hand, the offset voltage Vo is supplied to the one end of the capacitor 50. Since the voltage applied to the other end of the capacitor 50 is switched from the pulsed voltage Vp to the reference potential, the voltage value of the voltage signal SC applied to the extraction electrode 12 gradually decreases from the sum Vo + Vp according to the time constant determined by the capacitance of the capacitor 50 and the resistance of the resistor 52 and is kept constant at the offset voltage Vo.

For example, if the pulsed voltage Vp is 1.2 kV and the offset voltage Vo is 3.0 kV, the voltage value of the voltage signal SC applied to the extraction electrode 12 gradually decreases from 4.2 kV and is kept constant at 3.0 kV.

The offset voltage Vo is so set that the value of the emission current EC0 becomes equal to the electrical current Ic. Since the voltage signal SC having the offset voltage Vo is supplied to the extraction electrode 12, the electrical current value of the emission current EC0 of the electron beam emitted from the emitter 10 becomes equal to the current Ic.

At an instant t5, the reference signal generator 20 switches the logic level of the reference pulsed signal SAp from a high to a low level. Because the inverted signal SB of a high level is applied to the first switch 32 via the inverter 36, the first switch 32 is turned on. The reference pulsed signal SAp of a low level is directly applied to the second switch 34 and so the second switch 34 is turned off.

Under these conditions, the voltage applied to the other end of the capacitor 50 is switched from the reference potential to the pulsed voltage Vp. As a result, the voltage value of the voltage signal SC increases gradually and is kept constant at the sum of the offset voltage and the pulsed voltage Vp, i.e., Vo + Vp. In consequence, the electrical current value of the emission current EC0 of the electron beam emitted from the emitter 10 becomes equal to the current Ip.

During the period from the instant t3 to the instant t5, the blanking signal generator circuit 70 maintains the logic level of the blanking signal SD high. Therefore, during this period t3-t5, the blanker 14 blanks the electron beam and thus the emission current EC is zero during this period t3-t5.

The instant t5 is equivalent to the instant t1. The electron gun 100 operates such that the period from t1 to t5 is one cycle C. The electron gun 100 emits one pulse of electron beam in one cycle C from instant t1 to instant t5. The electron gun 100 emits an electron beam in a pulsed manner by repeating the cycle C.

The period of the reference pulsed signal SAp produced by the reference signal generator 20 and the duty ratio of the reference pulsed signal SAp can be set to any arbitrary values. Therefore, the electron gun 100 can emit a pulsed electron beam at a desired period. Furthermore, the pulse width of the emission current EC0 can be modified, for example, by varying the duty ratio of the reference pulsed signal SA. Since the offset voltage Vo and the pulsed voltage Vp can be set to any arbitrary values, the electron gun 100 can emit a pulsed electron beam having a desired peak intensity.

### 1.2.3. Continuous Emission Mode

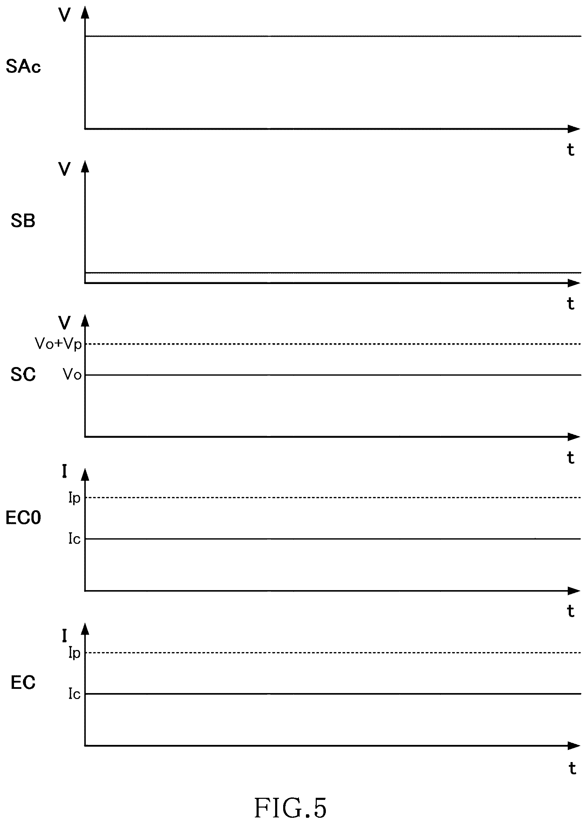

FIG. 5 is a graph showing the reference continuous signal SAc, inverted signal SB, voltage signal SC, emission current EC0, and emission current EC in the continuous emission mode. In the continuous emission mode, the reference signal generator 20 produces the reference continuous signal SAc as the reference signal SA. Also, in the continuous emission mode, the blanker 14 is not operated.

The reference signal generator 20 continues to output the reference continuous signal SAc of a high level. This maintains the first switch 32 off and the second switch 34 on. Consequently, the reference potential is kept applied to the other end of the capacitor 50. Thus, the voltage value of the voltage signal SC is kept constant at the offset voltage Vo. As a result, the electrical current value of the emission current EC0 of the electron beam emitted from the emitter 10 is kept constant at the electrical current Ic.

In the continuous emission mode, the blanker 14 does not operate and so the electrical current value of the emission current EC is kept constant at the electrical current Ic. In this way, in the continuous emission mode, the electron gun 100 emits an electron beam having a constant emission current.

### 1.3. Advantageous Effects

The electron gun 100 includes: the emitter 10; the extraction electrode 12 for extracting an electron beam from the emitter 10; the capacitor 50 whose one end is connected to the extraction electrode 12; the offset power supply 60 for supplying the offset voltage Vo to the one end of the capacitor 50 via the resistor 52; the pulsed power supply 40 providing an output of the pulsed voltage Vp; and the switch circuit 30 that switches between whether the pulsed voltage Vp or the reference potential is supplied to the other end of the capacitor 50 based on the reference pulsed signal SAp.

In the electron gun 100, the offset voltage Vo is connected to the one end of the capacitor 50, and the reference potential is connected to the other end of the capacitor 50. Under this condition, electric charge corresponding to the difference between the offset voltage Vo and the reference potential is stored in the capacitor 50. Then, the voltage at the other end of the capacitor 50 is switched from the reference potential to the pulsed voltage Vp based on the reference pulsed signal SAp. Consequently, the voltage applied to the extraction electrode can be varied in a pulsed manner. This makes it possible to vary the emission current EC0 in a pulsed manner. As a result, the number of electrons contained in each pulse can be increased.

Furthermore, in the electron gun 100, an extraction voltage higher than the withstand voltage of the switch circuit 30 can be applied to the extraction electrode 12. For example, if the withstand voltage of the switch circuit 30 is 1.5 kV, the voltage applied to the extraction electrode 12 is 4.2 kV by setting the pulse voltage Vp and the offset voltage Vo to 1.2 kV and 3.0 kV, respectively. In this way, in the electron gun 100, an extraction voltage higher than the withstand voltage of the switch circuit 30 can be applied to the extraction electrode 12.

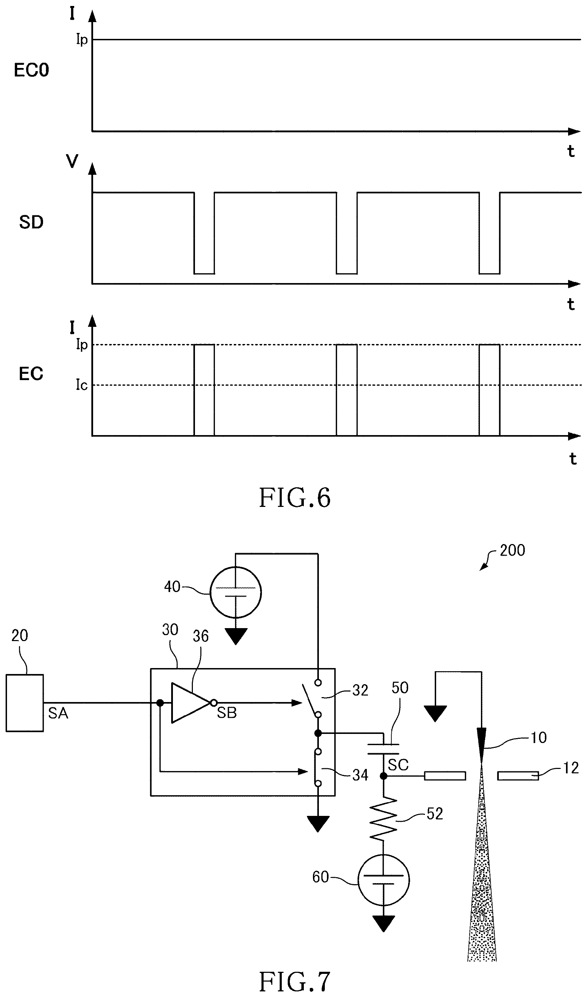

FIG. 6 illustrates a comparative example of the method of emitting an electron beam in a pulsed manner. For example, in the conventional Schottky emission gun or cold field emission gun, the emission current EC0 of the electron beam emitted from the emitter 10 is kept constant at the current Ip as shown in FIG. 6 and the beam is blanked by the blanker 14. Consequently, a pulsed electron beam having a peak intensity of current Ip can be emitted. The number of electrons contained in each pulse can be increased by increasing the emission current using the Schottky emission gun or cold field emission gun.

However, if the emission current EC0 of the electron beam is kept constant at the electrical current Ip, an electron beam having a large emission current strikes the electrodes and other parts for a long time, increasing the amount of produced gas. Furthermore, increasing the emission current induces a flow of a large current across the front end of the emitter. This may raise the temperature of the emitter itself or vary the shape of the front end of the emitter.

On the other hand, in the electron gun 100, the emission current EC0 of the electron beam emitted from the emitter 10 is varied in a pulsed manner such that its peak current value is the electrical current Ip as shown in FIG. 4. Therefore, the time for which the electrodes and other parts are irradiated with the electron beam can be shortened as compared to the case where the electrical current value of the emission current EC0 is kept constant at the current Ip as shown in FIG. 6. Consequently, the amount of gas released by the electron beam irradiation can be reduced. Furthermore, in the electron gun 100, the time for which a large current flows across the front end of the emitter 10 can be shortened and so temperature rises of the emitter itself and variations in the shape of the front end of the emitter can be reduced. For example, the pulse width of the emission current EC0 can be decreased by reducing the duty ratio of the reference pulsed signal SAp shown in FIG. 4. As a consequence, the time for which the electrodes and other parts are exposed to the electron beam can be reduced further. In addition, the time for which a large current flows across the front end of the emitter 10 can be reduced further.

Additionally, in the electron gun 100, deterioration of the emitter 10 or other cause leads to increases in the extraction voltage needed to obtain a desired emission current, i.e., the voltage value of the voltage signal SC. Also in this case, in the electron gun 100, a desired emission current EC0 can be obtained easily by increasing the offset voltage Vo and superimposing the pulsed voltage Vp.

The electron gun 100 includes the beam blanker 14 for blanking the electron beam. The blanker 14 blanks the beam in response to the blanking signal SD synchronized to the reference pulsed signals SAp. Therefore, in the electron gun 100, when the emission current EC0 is increased, the electron beam is allowed to pass by blanking and thus a pulsed electron beam can be obtained. Consequently, in the electron gun 100, the number of electrons contained in each pulse can be increased.

The electron gun 100 includes the blanking signal generator circuit 70 for generating the blanking signal SD. The switch circuit 30 supplies the pulsed voltage Vp during periods in which the reference pulsed signal SAp is at a low level, and supplies the reference potential during periods in which the reference pulsed signal SAp is at a high level. When the blanking signal SD is at a high level, the blanker 14 blanks the electron beam. When the blanking signal SD is at a low level, the blanker 14 unblanks the beam. When a given time Δt elapses since the logic level of the reference pulsed signal SAp is switched from a high to a low level, the blanking signal generator circuit 70 switches the blanking signal SD from a high to a low level and maintains the low level for a certain period P.

Therefore, in the electron gun 100, when the emission current EC0 varying in a pulsed manner increases, the electron beam is made to pass by blanking and thus a pulsed electron beam can be obtained. Consequently, in the electron gun 100, the number of electrons contained in each pulse can be increased.

It is to be noted that the above-described logic level scheme is merely exemplary and that the present invention is not restricted thereto. The switch circuit 30 supplies the pulsed voltage Vp during periods when the reference pulsed signal SAp is at a first logic level and supplies the reference potential during periods when the reference pulsed signal SAp is at a second logic level. The beam blanker 14 blanks the electron beam during periods when the blanking signal SD is at a third logic level and unblanks the beam during periods when the blanking signal SD is at a fourth logic level. After the given time Δt has elapsed since the logic level of the reference pulsed signal SAp is switched from the second logic level to the first logic level, the blanking signal generator circuit 70 switches the blanking signal SD from the third logic level to the fourth logic level and maintains the fourth logic level for the given period P. At this time, the first and second logic levels should be different from each other, and the third and fourth logic levels should be different from each other.

In the electron gun 100, the blanking signal generator circuit 70 has the given time Δt and the given period P specified and set by the user. Therefore, with the electron gun 100, an electron beam in the form of pulses having a desired pulse width can be extracted at desired timing using the beam blanker 14 from the electron beam whose emission current EC0 varies in a pulsed manner.

In the above embodiment, the blanking signal generator circuit 70 has the given time Δt and the given period P specified and set by the user. Alternatively, the blanking signal generator circuit 70 may have at least one of the given time Δt and the given period P specified and set by the user.

### 2. Second Embodiment

### 2.1. Electron Gun

An electron gun associated with a second embodiment is next described by referring to FIG. 7, which shows the structure of the electron gun, 200, associated with the second embodiment. In the following description, those members of the electron gun 200 which are similar in function to their respective counterparts of the electron gun 100 associated with the first embodiment are indicated by the same reference numerals as in the foregoing figures and a detailed description thereof is omitted.

In the above-described electron gun 100, as shown in FIG. 4, pulses are extracted from the electron beam emitted from the emitter 10 using the blanker 14, whereby the electron beam is emitted in a pulsed manner.

In contrast, in the electron gun 200, the electron beam is emitted in a pulsed manner from the emitter 10 without using the beam blanker 14. As shown in FIG. 7, the electron gun 200 is equipped with neither the blanker 14 nor the blanking signal generator circuit 70.

### 2.2. Operation

### 2.2.1. Emission of Electron Beam

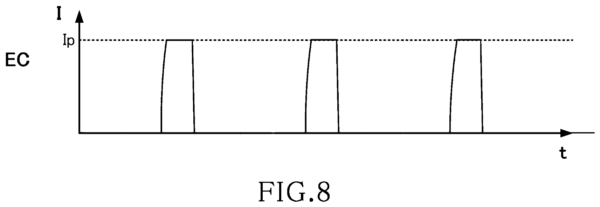

FIG. 8 is a graph showing the emission current EC of an electron beam emitted from the electron gun 200. The electron gun 200 can switch between the continuous emission mode in which an electron beam is emitted with a constant electrical current Ic as shown in FIG. 2 and the pulsed emission mode in which an electron beam is emitted in a pulsed manner in regular cycles as shown in FIG. 8.

### 2.2.2. Pulsed Emission Mode

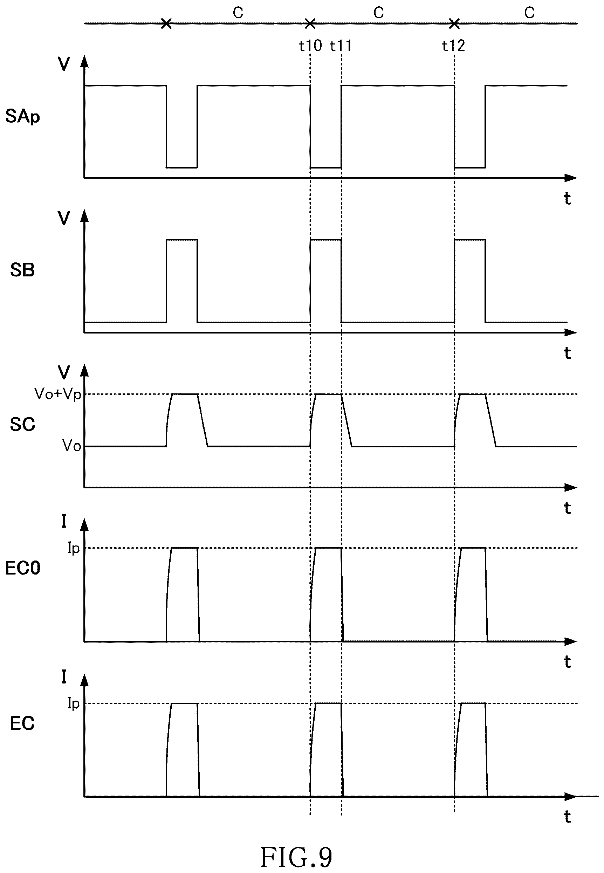

FIG. 9 is a graph showing the reference pulsed signal SAp, inverted signal SB, voltage signal SC, emission current EC0, and emission current EC in the pulsed emission mode. One end of the capacitor 50 is supplied with the offset voltage Vo. In the pulsed emission mode, the switch circuit 30 switches the voltage applied to the other end of the capacitor 50 between the pulsed voltage Vp and the reference potential based on the reference pulsed signal SA, thus varying the voltage signal SC in a pulsed manner. Consequently, the emission current EC0 varies in a pulsed manner. As a result, the electron gun 200 emits a pulsed electron beam.

In the following description, it is assumed that the electron gun 200 operates for one cycle C from an instant t10 to an instant t12. At the instant t10, the reference signal generator 20 switches the logic level of a reference pulsed signal SAp from a high to a low level. As a result, the inverted signal SB of a high level is applied to the first switch 32 via the inverter 36, thus turning on the first switch 32. The reference pulsed signal SAp of the low level is directly applied to the second switch 34, whereby the second switch 34 is turned off.

Because the first switch 32 is turned on and the second switch 34 is turned off, the voltage applied to the other end of the capacitor 50 switches from the reference potential to the pulsed voltage Vp. As a result, the voltage value of the voltage signal SC gradually increases from the offset voltage Vo according to a time constant determined by the capacitance of the capacitor 50 and the resistance value of the first switch 32 and settles at the sum of the offset voltage Vo and the pulsed voltage Vp (i.e., Vo + Vp). As a consequence, the emission current EC0 assumes an electrical current value of Ip.

Since the electron gun 200 does not have the blanker 14, the electron beam emanating from the emitter 10 is directly emitted from the gun 200. Accordingly, the emission current EC is equal to the emission current EC0.

At an instant t11, the reference signal generator 20 switches the logic level of the reference pulsed signal SAp from a low to a high level, so that the inverted signal SB of a low level is applied to the first switch 32 via the inverter 36. This turns off the first switch 32. The reference pulsed signal SAp of a high level is directly applied to the second switch 34, turning on the second switch 34.

Because the first switch 32 is turned off and the second switch 34 is turned on, the reference potential is supplied to the other end of the capacitor 50. That is, the voltage applied to the other end of the capacitor 50 is switched from the pulsed voltage Vp to the reference potential. On the other hand, the offset voltage Vo is supplied to the one end of the capacitor 50. Because the voltage applied to the other end of the capacitor 50 is switched from the pulsed voltage Vp to the reference potential, the voltage value of the voltage signal SC gradually decreases from the sum Vo + Vp according to the time constant determined by the capacitance of the capacitor 50 and the resistance value of the resistor 52 and settles at the offset voltage Vo.

In the above-described electron gun 100, the offset voltage Vo is so set that the electrical current value of the emission current EC0 is equal to the electrical current Ic. On the other hand, in the electron gun 200, the offset voltage Vo is set lower than the voltage necessary to emit an electron beam from the emitter 10. Therefore, supply of the voltage signal SC having a voltage value equal to the offset voltage Vo makes the electrical current value of the emission current EC0 zero.

At the instant t12, the reference signal generator 20 switches the logic level of the reference pulsed signal SAp from a high to a low level, whereby the inverted signal SB of a high level is applied to the first switch 32 via the inverter 36. This turns the first switch 32 on. Since the reference pulsed signal SAp of a low level is directly applied to the second switch 34, the second switch 34 is turned off.

Because the first switch 32 is turned on and the second switch 34 is turned off, the voltage applied to the other end of the capacitor 50 is switched from the reference potential to the pulsed voltage Vp. Consequently, the voltage value of the voltage signal SC gradually increases and settles at the sum of the offset voltage Vo and the pulsed voltage Vp, i.e., Vo + Vp. As a result, the electrical current value of the emission current EC0 becomes equal to the electrical current Ip.

The instant t12 is equivalent to the instant t10. The electron gun 200 operates such that the period from the instant t10 to the instant t12 is one cycle C. The electron gun 200 emits one pulse of electron beam in one cycle C from the instant t10 to the instant t12. The electron gun 200 emits a pulsed electron beam by repeating this cycle C.

### 2.2.3. Continuous Emission Mode

The operation of the electron gun 200 in the continuous emission mode is similar to the operation of the electron gun 100 in the continuous emission mode as illustrated in FIG. 5 and so a description thereof is omitted.

### 2.3. Advantageous Effects

The electron gun 200 includes the emitter 10, the extraction electrode 12 for extracting an electron beam from the emitter 10, the capacitor 50 whose one end is connected to the extraction electrode 12, the offset power supply 60 for supplying the offset voltage Vo to the one end of the capacitor 50 via the resistor 52, the pulsed power supply 40 for providing an output of the pulsed voltage Vp, and the switch circuit 30 for switching between whether the pulsed voltage Vp or the reference potential is applied to the other end of the capacitor 50 based on the reference pulsed signal SAp.

Therefore, in the electron gun 200, the number of electrons contained in each pulse of electron beam can be increased in the same manner as in the electron gun 100. Furthermore, in the electron gun 200, the amount of gas generated by irradiation of the electrodes and other parts with an electron beam can be reduced in the same manner as in the electron gun 100. In addition, in the electron gun 200, temperature rises of the emitter itself and variations in the shape of the front end of the emitter can be reduced in the same manner as in the electron gun 100.

### 2.4. Modification

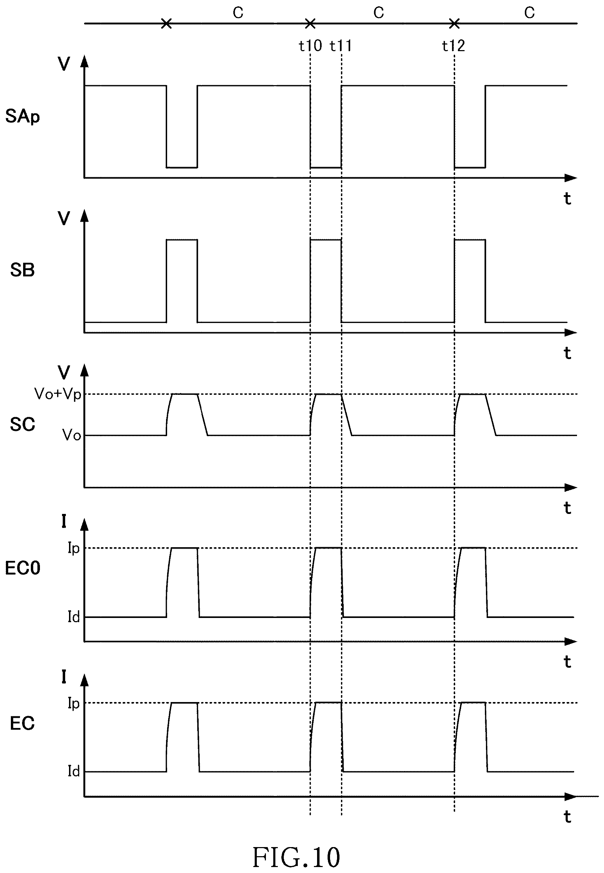

FIG. 10 is a graph showing the reference pulsed signal SAp, inverted signal SB, voltage signal SC, emission current EC0, and emission current EC in a modification of the pulsed emission mode. In the foregoing second embodiment, the offset voltage Vo is set lower than the voltage necessary to emit electrons from the emitter 10. Therefore, in the electron gun 200, if the voltage value of the voltage signal SC is the offset voltage Vo, the electrical current value of the emission current EC0 is zero. Accordingly, in the example of FIG. 9, the electron gun 200 emits an electron beam that is turned on and off cyclically and repetitively.

In contrast, the offset voltage Vo may allow the emission of an electron beam having an emission current of Id (Id ≠0) from the emitter 10. In this case, if the voltage signal SC is equal to the offset voltage Vo, the electrical current value of the emission current EC0 is the electrical current Id that is not zero. As a result, the electron gun 200 can emit an electron beam that is cyclically increased and decreased in intensity.

### 3. Third Embodiment

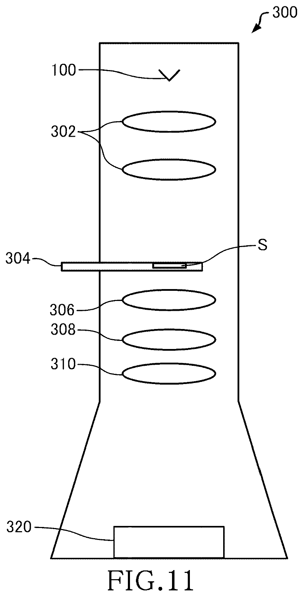

An electron microscope associated with a third embodiment is next described by referring to FIG. 11, which shows the configuration of the electron microscope, 300, associated with the third embodiment. The electron microscope 300 includes the electron gun 100 as shown and described below. Alternatively, the electron microscope 300 may include the electron gun 200.

As shown in FIG. 11, the electron microscope 300 includes an illumination optics 302, a sample stage 304, an objective lens 306, an intermediate lens 308, a projector lens 310, and an imager 320, as well as the electron gun 100.

The electron gun 100 emits an electron beam. The electron gun 100 can switch between the continuous emission mode in which the electron beam is emitted at a constant emission current as illustrated in FIG. 2 and the pulsed emission mode in which the electron beam is emitted in a pulsed manner as illustrated in FIG. 3. Therefore, the electron microscope 300 can either direct an electron beam with a constant emission current at a sample S or direct a pulsed electron beam at the sample S.

The illumination optics 302 includes a plurality of lenses for directing an electron beam at the sample S, and focuses the electron beam onto the sample S. The illumination optics 302 may include apertures, deflectors, and other parts, as well as the lenses. The beam blanker 14 may be built in the illumination optics 302.

The sample stage 304 mechanically holds the sample S and has a drive mechanism for moving the sample S horizontally and vertically and a tilt mechanism for tilting the sample S. The field of view of the transmission electron microscope (TEM) image can be moved by moving the sample S by means of the sample stage 304.

The electron beam transmitted through the sample S is focused as a TEM image by the objective lens 306. The intermediate lens 308 and projector lens 310 cooperate to project the image created by the objective lens 306 onto the imager 320. The objective lens 306, intermediate lens 308, and projector lens 310 together constitute an imaging optics for focusing the TEM image.

The imager 320 captures the TEM image focused by the imaging optics. The imager 320 is a CCD (charge coupled device) camera, a CMOS (complementary metal-oxide-semiconductor) camera, or the like, for example.

In the electron microscope 300, the electron beam emitted from the electron gun 100 is focused into an electron probe by the illumination optics 302, and the sample S is scanned with the electron probe by deflecting the electron beam by means of a deflector (not shown). Electrons transmitted through the sample S are detected and thus an STEM (scanning transmission electron microscope) image can be obtained. That is, the electron microscope 300 functions also as a scanning transmission electron microscope.

In the foregoing description, the electron gun 100 is applied to a transmission electron microscope. The electron gun 100 can be applied also to other charged particle beam systems. Examples of such charged particle beam systems include scanning electron microscopes, electron probe microanalyzers, Auger microprobes, and electron beam lithography systems.

### 4. Modification

It is to be understood that the present invention is not restricted to the foregoing embodiments but rather can be implemented in various modified forms without departing from the gist of the present invention.

For example, in the first and second embodiments described above, the charged particle gun associated with the present invention is an electron gun that emits an electron beam. The charged particle gun associated with the present invention may also emit a charged particle beam other than an electron beam such as an ion beam. For example, an ion gun that emits an ion beam can be implemented by varying the polarities of the emitter 10 and extraction electrode 12 shown in FIG. 1.

Furthermore, in the description of the third embodiment described above, the charged particle beam system associated with the present invention is an electron microscope equipped with the electron gun 100. A charged particle beam system associated with the present invention may also be a charged particle beam system equipped with an ion gun. An example of such a charged particle beam system is a focused ion beam system.

The present invention is not restricted to the foregoing embodiments but rather various modifications may be possible. For example, the present invention embraces configurations (e.g., configurations identical in function or method) which are substantially identical to the configurations described in any one of the above embodiments. Furthermore, the invention embraces configurations which are similar to the configurations described in any one of the above embodiments except that their nonessential portions have been replaced. Further, the invention embraces configurations which are similar to the configurations described in any one of the above embodiments except that a well-known technique is added.

## Claims

1. A charged particle gun for emitting a charged particle beam, comprising:
an emitter (10);
an extraction electrode (12) for extracting the charged particle beam from the emitter;
a capacitor (50) having one end connected to the extraction electrode;
a first power supply (60) for supplying a first voltage to the one end of the capacitor via a resistor (52);
a second power supply (40) providing an output of a second voltage; and
a switch circuit (30) that switches between whether the second voltage or a reference potential is supplied to the other end of the capacitor, based on a reference pulsed signal.

2. A charged particle gun as set forth in claim 1, further comprising a beam blanker (14) for blanking said charged particle beam in response to a blanking signal synchronized to said reference pulsed signal.

3. A charged particle gun as set forth in claim 2, further comprising a blanking signal generator circuit (70) for generating said blanking signal;
wherein said switch circuit supplies said second voltage during periods when said reference pulsed signal is at a first logic level and supplies said reference potential during periods when the reference pulsed signal is at a second logic level;
wherein said beam blanker blanks said charged particle beam during periods when the blanking signal is at a third logic level and unblanks the charged particle beam during periods when the blanking signal is at a fourth logic level; and
wherein after an elapse of a given time since the logic level of said reference pulsed signal is switched from said second logic level to said first logic level, said blanking signal generator circuit switches the blanking signal from the third logic level to the fourth logic level and maintains the fourth logic level for a certain period of time.

4. A charged particle gun as set forth in claim 3, wherein said blanking signal generator circuit permits a user to specify and set at least one of said given time and said certain period of time.

5. A charged particle gun as set forth in any one of claims 1 to 4, wherein said switch circuit switches between whether said second voltage or said reference potential is supplied to the other end of said capacitor based on said reference pulsed signal, whereby the emission current of the charged particle beam emitted from the emitter is varied in a pulsed manner.

6. A charged particle gun as set forth in any one of claims 1 to 5, wherein said first voltage is set lower than a voltage necessary to emit the charged particle beam from said emitter.

7. A charged particle beam system including a charged particle gun as set forth in any one of claims 1 to 6.

## Patentansprüche

1. Ladungsträgerteilchenkanone zum Emittieren eines Ladungsträgerteilchenstrahls, umfassend:
einen Emitter (10);
eine Extraktionselektrode (12) zum Extrahieren des Ladungsträgerteilchenstrahls aus dem Emitter;
einen Kondensator (50), dessen eines Ende mit der Extraktionselektrode verbunden ist;
eine erste Stromzufuhr (60) zum Zuführen einer ersten Spannung zu dem einen Ende des Kondensators über einen Widerstand (52);
eine zweite Stromzufuhr (40), die eine Ausgabe einer zweiten Spannung bereitstellt; und
eine Schalterschaltung (30), die schaltet zwischen ob die zweite Spannung oder ein Referenzpotential dem anderen Ende des Kondensators zugeführt wird, basierend auf einem Referenzimpulssignal.

2. Ladungsträgerteilchenkanone nach Anspruch 1, die ferner einen Strahlausblender (14) zum Ausblenden des Ladungsträgerteilchenstrahls ansprechend auf ein Ausblendsignal, das mit dem Referenzimpulssignal synchronisiert ist, umfasst.

3. Ladungsträgerteilchenkanone nach Anspruch 2, die ferner eine Ausblendsignal-Erzeugerschaltung (70) zum Erzeugen des Ausblendsignals umfasst;
wobei die Schalterschaltung die zweite Spannung während Zeiträumen zuführt, in denen das Referenzimpulssignal auf einem ersten Logikpegel ist, und das Referenzpotential während Zeiträumen zuführt, in denen das Referenzimpulssignal auf einem zweiten Logikpegel ist;
wobei der Strahlausblender den Ladungsträgerteilchenstrahl während Zeiträumen ausblendet, in denen das Ausblendsignal auf einem dritten Logikpegel ist, und den Ladungsträgerteilchenstrahl während Zeiträumen freigibt, in denen das Ausblendsignal auf einem vierten Logikpegel ist; und
wobei nach Ablauf einer vorgegebenen Zeit, seitdem der Logikpegel des Referenzimpulssignals von dem zweiten Logikpegel auf den ersten Logikpegel umgeschaltet wurde, die Ausblendsignal-Erzeugerschaltung das Ausblendsignal von dem dritten Logikpegel auf den vierten Logikpegel umschaltet und den vierten Logikpegel für eine bestimmte Zeitdauer aufrechterhält.

4. Ladungsträgerteilchenkanone nach Anspruch 3, wobei die Ausblendsignal-Erzeugerschaltung es einem Benutzer ermöglicht, mindestens eine der vorgegebenen Zeit und der bestimmten Zeitdauer zu spezifizieren und einzustellen.

5. Ladungsträgerteilchenkanone nach einem der Ansprüche 1 bis 4, wobei die Schalterschaltung schaltet zwischen ob die zweite Spannung oder das Referenzpotential dem anderen Ende des Kondensators zugeführt wird, basierend auf einem Referenzimpulssignal, wodurch der Emissionsstrom des Ladungsträgerteilchenstrahls, der aus dem Emitter emittiert wird, impulsartig variiert wird.

6. Ladungsträgerteilchenkanone nach einem der Ansprüche 1 bis 5, wobei die erste Spannung niedriger eingestellt ist als eine Spannung, die erforderlich ist, um den Ladungsträgerteilchenstrahl aus dem Emitter zu emittieren.

7. System für Ladungsträgerteilchenstrahlen, das eine Ladungsträgerteilchenkanone nach einem der Ansprüche 1 bis 6 umfasst.

## Revendications

1. Canon à particules chargées destiné à émettre un faisceau de particules chargées, comprenant :
un émetteur (10) ;
une électrode d'extraction (12) pour extraire le faisceau de particules chargées à partir de l'émetteur ;
un condensateur (50) présentant une certaine extrémité connectée à l'électrode d'extraction ;
une première alimentation électrique (60) pour fournir une première tension à la certaine extrémité du condensateur via une résistance (52) ;
une seconde alimentation électrique (40) fournissant une sortie d'une seconde tension ; et
un circuit de commutation (30) qui commute entre la seconde tension ou un potentiel de référence qui est fourni (e) à l'autre extrémité du condensateur, sur la base d'un signal pulsé de référence.

2. Canon à particules chargées selon la revendication 1, comprenant en outre un dispositif d'occultation de faisceau (14) pour occulter ledit faisceau de particules chargées en réponse à un signal d'occultation synchronisé par rapport audit signal pulsé de référence.

3. Canon à particules chargées selon la revendication 2, comprenant en outre un circuit générateur de signal de suppression (70) pour générer ledit signal de suppression ;
dans lequel ledit circuit de commutation fournit ladite seconde tension pendant des périodes où ledit signal pulsé de référence est à un premier niveau logique et fournit ledit potentiel de référence pendant des périodes où le signal pulsé de référence est à un deuxième niveau logique ;
dans lequel ledit dispositif d'occultation de faisceau occulte ledit faisceau de particules chargées pendant des périodes où le signal d'occultation est à un troisième niveau logique et désocculte le faisceau de particules chargées pendant des périodes où le signal d'occultation est à un quatrième niveau logique ; et
dans lequel après un laps d'un temps donné depuis que le niveau logique dudit signal pulsé de référence est commuté dudit deuxième niveau logique audit premier niveau logique, ledit circuit générateur de signal d'occultation commute le signal d'occultation du troisième niveau logique au quatrième niveau logique et maintient le quatrième niveau logique pendant une certaine période de temps.

4. Canon à particules chargées selon la revendication 3, dans lequel ledit circuit générateur de signal d'occultation permet à un utilisateur de spécifier et de définir au moins un parmi ledit temps donné et ladite certaine période de temps.

5. Canon à particules chargées selon l'une quelconque des revendications 1 à 4, dans lequel ledit circuit de commutation commute entre ladite seconde tension ou ledit potentiel de référence qui est fourni(e) à l'autre extrémité dudit condensateur sur la base dudit signal pulsé de référence, moyennant quoi le courant d'émission du faisceau de particules chargées émis par l'émetteur varie de manière pulsée.

6. Canon à particules chargées selon l'une quelconque des revendications 1 à 5, dans lequel ladite première tension est définie inférieure à une tension nécessaire pour émettre le faisceau de particules chargées à partir dudit émetteur.

7. Système de faisceau de particules chargées incluant un canon à particules chargées selon l'une quelconque des revendications 1 à 6.
